# EUROPÄISCHE PATENTSCHRIFT

(11) **EP 2 329 694 B1**
(45) Veröffentlichungstag und Bekanntmachung des Hinweises auf die Patenterteilung: **13.11.2013**
(21) Anmeldenummer: 09782482.5
(22) Anmeldetag: 02.09.2009
(51) Int. Cl.: H05K 1/03

(54) **BESCHICHTUNGEN FÜR ELEKTRONISCHE SCHALTUNGEN**
COATINGS FOR ELECTRONIC CIRCUITS
REVÊTEMENTS POUR CIRCUITS ÉLECTRONIQUES

(30) Priorität: 25.09.2008 DE 102008048874
(43) Veröffentlichungstag der Anmeldung: 08.06.2011
(73) Patentinhaber: Siemens Aktiengesellschaft, 80333 München (DE)
(72) Erfinder: BROCKSCHMIDT, Mario, 45131 Essen (DE); BUCKL, Sabrina, 91058 Erlangen (DE); GRÖPPEL, Peter, 91052 Erlangen (DE); RICHTER, Markus, 93133 Burglengenfeld (DE); SCHWEIZER, Michael, 89075 Ulm (DE)
(86) Internationale Anmeldenummer: PCT/EP2009/061305
(87) Internationale Veröffentlichungsnummer: WO 2010/034596

(56) Entgegenhaltungen:
- WO-A-2005/066252
- JP-A- 2007 129 215
- US-A1- 2007 077 413

## Beschreibung

Moderne elektronische Schaltungen müssen besonderen stetig steigenden Anforderungen genügen. Die konstruktiven Forderungen nach großer Schaltungsdichte, gleichbedeutend mit dicht benachbarten elektronischen Bauteilen und nahe beieinander liegenden Leiterbahnen sind aus der Notwendigkeit abzuleiten, immer mehr Elektronik in einem komplexen System unterzubringen.

Je kleiner das Design elektronischer Schaltungen ist, desto größer wird allerdings die Gefahr von Ausfällen der Isolierungen und Schutzsysteme aufgrund z.B. von Temperaturwechselbelastungen, Stoßströmen, Kriechströmen und Durchschlägen. Äußere Teilentladungen (Koronaentladungen) und das Auftreten von Treeingerscheinungen durch innere Teilentladungen sind visuell kaum erfassbar, können aber zur Erosion von Material und schließlich zum Durchschlag oder Überschlag zwischen zwei auf unterschiedlichen Potentialen liegenden elektrischen Leitern führen.

Die US2007/0077413 beschreibt zur Verringerung dielektrischer Verluste einen Schutzlack für Leiterplatten auf Harzbasis, der ein anorganisches Oxid enthält.

Die WO 2007/045633 offenbart eine optimierte homogene Beschichtung für elektromagnetische Vorrichtungen mit verbesserter elektrischer Isolierung und Korrosionsschutz. Diese besteht aus kommerziell erhältlichen Beschichtungsmaterialien und einem Nanomaterial, welches zu 1-5 Gew.-% dem Beschichtungsmaterial zugefügt sein kann. Beide Materialien werden zusammengemischt und als homogene Beschichtungslösung auf die elektromagnetische Vorrichtung gegeben. Das Nanomaterial macht die Zugabe weiterer Absetzmittel überflüssig und verändert die Rheologie der Mixtur nicht signifikant.

Die Größenordnung für den Teilchendurchmesser der Partikel ist mit 1 -150 nm angegeben (siehe Anspruch 2). Weitere Aussagen über mögliche Vorteile eines spezifischeren Partikelgrößenbereiches und einer spezifischen Breitenverteilung der Nanopartikel-Durchmesser werden hingegen nicht gemacht.

Es stellt sich somit die Aufgabe, Beschichtungen für elektronische Schaltungen zu finden, bei denen die oben erwähnten Nachteile zumindest teilweise überwunden werden können und bei denen insbesondere eine erhöhte Teilentladungsfestigkeit erreicht werden kann.

Diese Aufgabe wird durch eine Beschichtung gemäß Anspruch 1 der vorliegenden Erfindung gelöst. Dementsprechend wird eine Schutzlack-Beschichtung für Leiterplatten elektronischer Schaltungen auf Harzbasis vorgeschlagen, enthaltend mindestens ein nanopartikuläres anorganisches Oxid dadurch gekennzeichnet, dass das nanopartikuläre Oxid im Durchschnitt einen Teilchendurchmesser von ≥10 und ≤90 nm und das die Streuung der Durchmesser des mindestens einen nanopartikulären Oxids eine Halbwertsbreite σ von ≤10 nm aufweisen.

Die Bezeichnung "Schutzlack-Beschichtung" umfasst und/oder bedeutet dabei insbesondere eine Materialschicht, die zum Schutz auf eine Oberfläche aufgebracht wird. Nicht einschränkende Beispiele für erfindungsgemäße Schutzlack-Beschichtungen sind insbesondere solche Beschichtungen, welche Substrate vor Umwelteinflüssen schützen, z. B.: Korrosion von Lötverbindungen, Feuchtigkeit, Schimmel, Kraftstoffe und Prozesslösemittel, Betriebstemperaturen sowie Staub, Schmutz und physische Beschädigung bei der Handhabung.

Die Bezeichnung "Harzbasis" umfasst und/oder bedeutet dabei insbesondere, dass die Schutzlack-Beschichtung zum größten oder wesentlichen Teil aus einem organischen Material aufgebaut ist, welches eine hohe Viskosität aufweist. Bevorzugte Harze sind dabei Epoxidharze, Polyurethanharze, Aminoplasten, ABS-Plasten.

Die Bezeichnung "nanopartikulär" umfasst und/oder bedeutet dabei insbesondere einen im Wesentlichen kugelartigen Aufbau, wobei der durchschnittliche Durchmesser der Kugeln unterhalb von 100nm liegt.

Die Bezeichnung "anorganisches Oxid" umfasst und/oder bedeutet dabei insbesondere alle festen Oxid, Oxid-Hydroxid, Oxid-Nitrid Verbindungen von Nicht-Kohlenstoff-Verbindungen.

Überraschend hat sich herausgestellt, dass eine derartige erfindungsgemäße Schutzlack-Beschichtung bei den meisten Anwendungen eine drastisch erhöhte Teilentladungsfestigkeit aufweist, so dass die eingangs erwähnten Probleme häufig drastisch vermindert oder sogar ganz beseitigt werden können.

Weiterhin konnten bei den meisten Anwendungen der Erfindung mindestens einer der folgenden Vorteile aufgefunden bzw. erzielt werden:
- eine stark verbesserte Kratzbeständigkeit
- Barriere-Effekte gegen Gase, Wasserdampf und Lösemittel
- Erhöhte Witterungsbeständigkeit und verlangsamte thermische Alterung
- Verringerung des Härtungsschrumpf und Reaktionswärme
- Verringerte thermische Ausdehnung und innere Spannung
- Erhöhung der Reißfestigkeit, Bruchzähnigkeit und Elastizitätsmodul
- Verbesserte Haftung auf zahlreichen anorganischen und organischen Substraten
- Verringerte Brandlast
- Keine flüchtigen organischen Verbindungen
- Anwendungsfreundlichkeit, da ein Ein-Komponentensystem

Bevorzugt weist die Streuung der Durchmesser des mindestens einen nanopartikuläre Oxids eine Halbwertsbreite σ von ≤10 nm, ferner bevorzugt ≤8 nm, noch bevorzugt ≤5 nm, sowie am meisten bevorzugt ≤3 nm auf.

Gemäß einer bevorzugten Ausführungsform der Erfindung wobei das nanopartikuläre Oxid ein Material enthält, ausgewählt aus der Gruppe enthaltend Al₂O₃, AlOOH, SiO₂, TiO₂, GeO₂, Schichtsilikate und organisch modifizierte Schichtsilikate, BN, A13N4, und Mischungen daraus.

Gemäß einer bevorzugten Ausführungsform der Erfindung ist das mindestens eine nanopartikuläre anorganische Oxid dispers in der Beschichtung verteilt.

Dies hat sich als vorteilhaft herausgestellt, da so meist eine Härtung durch UV (zur Herstellung z.B. eines Epoxidharzes) problemlos möglich ist.

Gemäß einer bevorzugten Ausführungsform der Erfindung beträgt der Anteil des nanoparikulären anorganischen Oxids in der Schutzlack-Beschichtung (Gewicht/Gewicht) von ≥5 % bis ≤60 %. Dies hat sich in der Praxis besonders bewährt, da so die vorteilhaften Eigenschaften oftmals besonders gut erzielt werden können bei gleichzeitiger guter Handhabbarkeit der Beschichtung.

Bevorzugt beträgt der Anteil des nanoparikulären anorganischen Oxids in der Schutzlack-Beschichtung (Gewicht/Gewicht) von ≥10 % bis ≤50 %, noch bevorzugt ≥15 % bis ≤40 %.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in denen - beispielhaft - mehrere Ausführungsbeispiele der erfindungsgemäßen Beschichtung dargestellt sind. In den Zeichnungen zeigt:
- Fig. 1: eine Darstellung einer Toeplerschen Gleitanordnung einer erfindungsgemäßen Schutzlack-Beschichtung; sowie
- Fig. 2: eine Darstellung einer Toeplerschen Gleitanordnung einer Schutzlack-Beschichtung nach dem Stand der Technik.

### Beispiel I

Die vorliegende Erfindung wird - rein illustrativ - an folgendem Beispiel I dargestellt, welche eine Schutzlack-Beschichtung gemäß einer ersten Ausführungsform der Erfindung darstellt.

In dieser Beschichtung wurden SiO₂-Partikel mit einer Partikelgröße von ca. 20 nm (Halbwertsbreite ca. 10 nm) in einem Epoxidharz (Bisphenol-A-Diglcidylether) dispergiert. Der Massenanteil der SiO₂-Partikel im Harz betrug ca. 40%.

Als Vergleichsbeispiel wurde ein Harz ohne Nanopartikel gewählt.

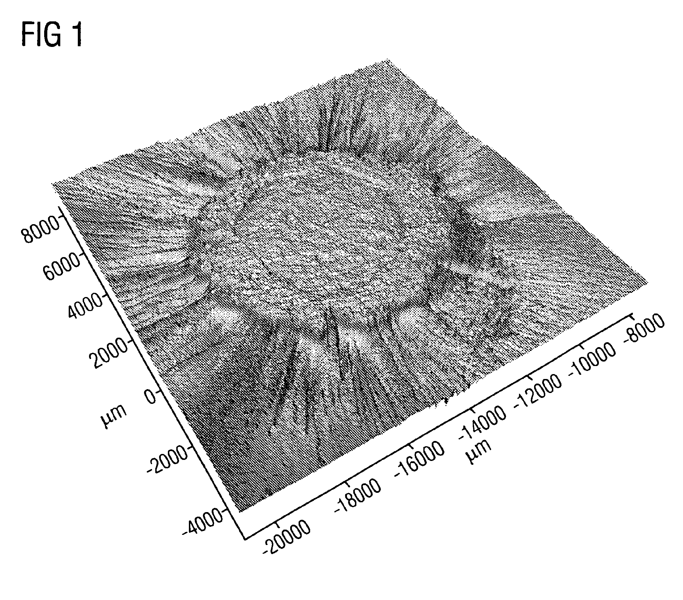

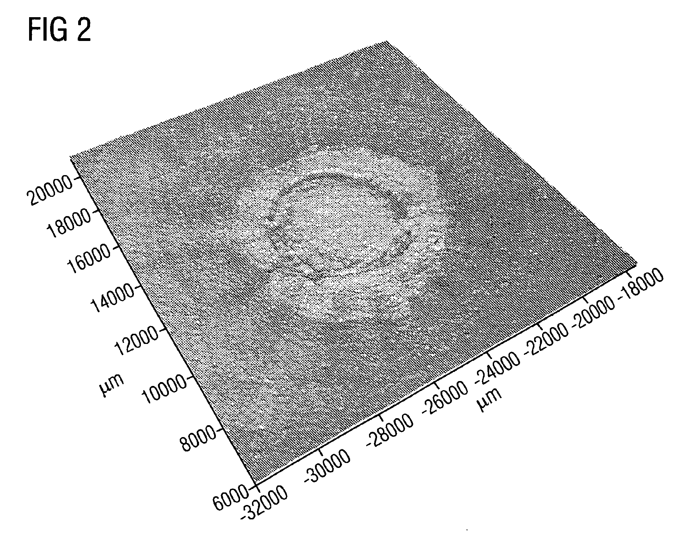

Fig. 1 und 2 zeigen die Teilentladungsfestigkeit der Beschichtungen anhand einer Toeplerschen Gleitanordnung. Dabei wurden die Beschichtungen auf eine erdseitig kontaktierte Kupferelektrode gelegt. Auf den Beschichtungen wurde eine Zylinderelektrode mit 1mm Radius Querschnitt aufgesetzt, dabei entstehen im Zwickel bei konstanter Spannung örtlich begrenzte äußere Teilentladungen, die für eine Erosion des Materials sorgen.

Fig. 1 und 2 zeigen die Beschichtungen nach 240h Alterung bei einer elektrischen Feldstärke von 13 kV/mm. Dabei ergab sich für die nanopartikulär gefüllte Probe ein erodiertes Gesamtvolumen von 1,69 mm² und eine maximale Erosionstiefe von 34 µm, für die ungefüllte Probe hingegen eine maximale Erosionstiefe von 194 µm und ein Erosionsvolumen von 7 mm².

### Beispiel II

In einem weiteren Beispiel wurde eine weitere erfindungsgemäße Beschichtung hergestellt und anhand einer Toeplerschen Gleitanordnung untersucht. In dieser Beschichtung wurden Al₂O₃-Partikel mit einer Partikelgröße von ca. 40 nm (Halbwertsbreite ca. 20 nm) in einem Epoxidharz (Bisphenol-A-Diglcidylether) dispergiert. Der Massenanteil der Partikel im Harz betrug ca. 20%.

Dabei ergab sich für die nanopartikulär gefüllte Probe ein erodiertes Gesamtvolumen von 2,30 mm² und eine maximale Erosionstiefe von 50 µm.

### Beispiel II

In einem weiteren Beispiel wurde eine weitere erfindungsgemäße Beschichtung hergestellt und anhand einer Toeplerschen Gleitanordnung untersucht. In dieser Beschichtung wurden TiO₂-Partikel mit einer Partikelgröße von ca. 35 nm (Halbwertsbreite ca. 20 nm) in einem Epoxidharz (Bisphenol-A-Diglcidylether) dispergiert. Der Massenanteil der TiO₂-Partikel im Harz betrug ca. 15%.

Dabei ergab sich für die nanopartikulär gefüllte Probe ein erodiertes Gesamtvolumen von 2,85 mm² und eine maximale Erosionstiefe von 55 µm.

## Patentansprüche

1. Schutzlack-Beschichtung für Leiterplatten elektronischer Schaltungen auf Harzbasis, enthaltend mindestens ein anorganisches nanopartikuläres Oxid,
**dadurch gekennzeichnet, dass**
das nanopartikuläre Oxid im Durchschnitt einen Teilchendurchmesser von ≥10 und ≤90 nm und das die Streuung der Durchmesser des mindestens einen nanopartikulären Oxids eine Halbwertsbreite σ von ≤10 nm aufweisen.

2. Beschichtung nach Anspruch 1,
**dadurch gekennzeichnet, dass**
das nanopartikuläre Oxid ein Material enthält, ausgewählt aus der Gruppe enthaltend Al₂O₃, AlOOH, SiO₂, TiO₂, GeO₂ und Mischungen daraus.

3. Beschichtung nach einem der Ansprüche 1 bis 2,
**dadurch gekennzeichnet, dass**
das mindestens eine nanopartikuläre anorganische Oxid dispers in der Beschichtung verteilt ist.

4. Beschichtung nach einem der Ansprüche 1 bis 3,
**dadurch gekennzeichnet, dass**
der Anteil des nanopartikulären anorganischen Oxids in der Schutzlack-Beschichtung (Gewicht/Gewicht) von ≥5 % bis ≤60 % beträgt.

## Claims

1. Resin-based protective lacquer coating for printed circuit boards of electronic circuits, containing at least one nanoparticulate inorganic oxide,
**characterised in that**
the nanoparticulate oxide has on average a particle diameter of ≥10 and ≤90 nm and that the variation of the diameters of the at least one nanoparticulate oxide has a half width σ of ≤10 nm.

2. Coating according to claim 1,
**characterised in that**
the nanoparticulate oxide contains a material, selected from the group containing Al₂O₃ , AlOOH, SiO₂, TiO₂, GeO₂ and mixtures thereof.

3. Coating according to one of claims 1 to 2,
**characterised in that**
the at least one nanoparticulate inorganic oxide is dispersed in the coating.

4. Coating according to one of claims 1 to 3,
**characterised in that**
the proportion of the nanoparticulate inorganic oxide in the protective lacquer coating (weight/weight) is from ≥5% to ≤60%.

## Revendications

1. Revêtement à vernis protecteur pour plaquettes de circuits électroniques à base de résine, contenant au moins un oxyde nanoparticulaire anorganique,
**caractérisé en ce que**
l'oxyde nanoparticulaire présente en moyenne un diamètre de particules de ≥ 10 et ≤ 90 nm et la dispersion des diamètres de l'au moins un oxyde nanoparticulaire présente une largeur de valeur moyenne σ de ≤ 10 nm.

2. Revêtement selon la revendication 1,
**caractérisé en ce que**
l'oxyde nanoparticulaire contient un matériau sélectionné dans le groupe contenant Al₂O₃, AlOOH, SiO₂ TiO₂, GeO₂ et des mélanges de ceux-ci.

3. Revêtement selon l'une des revendications 1 à 2,
**caractérisé en ce que**
l'au moins un oxyde anorganique nanoparticulaire est réparti de manière dispersée dans le revêtement.

4. Revêtement selon l'une des revendications 1 à 3,
**caractérisé en ce que**
la part de l'oxyde anorganique nanoparticulaire dans le revêtement à vernis protecteur (poids/poids) va de ≥ 5 % à ≤ 60 %.
